# EUROPÄISCHE PATENTSCHRIFT

(11) **EP 1 097 514 B1**
(45) Veröffentlichungstag und Bekanntmachung des Hinweises auf die Patenterteilung: **21.04.2004**
(21) Anmeldenummer: 99932854.5
(22) Anmeldetag: 08.07.1999
(51) Int. Cl.: H03K 17/96

(54) **ANSCHLUSSVORRICHTUNG FÜR GESCHIRMTE FLÄCHENELEKTRODE**
CONNECTION DEVICE FOR A SCREENED SURFACE ELECTRODE
DISPOSITIF DE CONNEXION POUR UNE ELECTRODE PLATE BLINDEE

(30) Priorität: 22.07.1998 LU 90265
(43) Veröffentlichungstag der Anmeldung: 09.05.2001
(73) Patentinhaber: IEE INTERNATIONAL ELECTRONICS & ENGINEERING S.A., 6468 Echternach (LU)
(72) Erfinder: HAUER, Ernst, Johann, L-6586 Steinheim (LU)
(74) Vertreter: Beissel, Jean
(86) Internationale Anmeldenummer: PCT/EP1999/004810
(87) Internationale Veröffentlichungsnummer: WO 2000/005817

(56) Entgegenhaltungen:
- EP-A- 0 409 380
- DE-A- 2 603 187
- DE-A- 3 608 477
- DE-A- 19 723 420
- FR-A- 1 586 612
- FR-A- 2 271 538

## Beschreibung

Die vorliegende Erfindung betrifft eine Anschlußvorrichtung für eine geschirmte Flächenelektrode, insbesondere für eine kapazitive Sensorelektrode zur Personenerkennung in einem Fahrzeug.

Das Prinzip der kapazitiven Personenerkennung in einem Fahrzeug beruht auf der Erfassung kapazitiver Veränderungen im Umfeld des jeweiligen Fahrzeugsitzes. Bei der Erfassung dieser Veränderungen mittels eines kapazitiven Sensors wird die Tatsache ausgenutzt, daß ein vorhandener Körper eine gewisse Kapazität gegenüber einer Meßelektrode aufweist, die von der Position des Körpers zu der Meßelektrode abhängig ist.

Der kapazitive Sensor umfaßt dazu eine flächige Meßelektrode, die beispielsweise in die Rückenlehne oder die Sitzfläche eines Fahrzeugsitzes eingebaut ist und die mit einer Wechselspannung beaufschlagt wird. Um kapazitive Feldveränderungen durch Personen oder Gegenstände zu vermeiden, die hinter der Erfassungsfläche, d.h. hinter dem Fahrzeugsitz, angeordnet sind, ist hinter der Meßelektrode in einem gewissen Abstand eine ebenfalls flächige Abschirmelektrode angeordnet, die mit der gleichen Wechselspannung beaufschlagt wird. Die Abschirmelektrode hat vorzugsweise eine größere Ausdehnung als die eigentliche Meßelektrode, so daß das von der Meßelektrode erzeugte Wechselfeld wirksam nach vorne hin begrenzt wird.

Eine auf den Fahrzeugsitz sitzende Person befindet sich demnach in dem kapazitiven Feld der mit Wechselspannung beaufschlagten Meßelektrode und es fließt ein Strom von der Meßelektrode über die Person zur Masse, der der Kapazität zwischen dem Körper der Person und der Meßelektrode proportional ist. Über die Messung des abfließenden Stroms kann dann die Position einer Person bezüglich der Rückenlehne des Fahrzeugsitzes bestimmt werden.

Die Kontaktierung einer derartigen Flächenelektrode geschieht üblicherweise dadurch, daß an beide Elektroden im Randbereich jeweils ein Kabel angelötet wird und die Lötstelle zur Verbesserung der mechanischen Eigenschaften der Verbindungsstelle mit einem Kunststoff vergossen wird. An das freie Ende der beiden Kabel wird dann ein Stecker montiert, an den beim Einbau der Elektrode in den Fahrzeugsitz die Spannungsversorgung der beiden Elektroden angeschlossen wird.

Ein Nachteil an dieser Art der Kontaktierung ist der hohe Arbeitsaufwand bei der Herstellung der Kontaktierung nachdem die Flächenelektrode zusammengebaut ist. In der Tat läßt eine derartige Kontaktierung kaum eine Verwendung von vorgefertigten Teilen zu, sondern die einzelnen die Leiter müssen in verschiedenen Arbeitsschritten zunächst an die jeweilige Elektrode montiert werden und anschließend die Kontaktstelle in einem weiteren Arbeitsgang vergossen werden.

Da die Meßelektrode im allgemeinen deutlich kleiner ist als die dahinterliegende Abschirmelektrode ist es mit dieser Art der Kontaktierung darüber hinaus nicht möglich eine durchgehend geschirmte Kontaktierung der Elektroden herzustellen. Selbst bei Verwendung einer geschirmten Anschlußleitung, wobei der Außenleiter mit der Abschirmelektrode und der Innenleiter mit der Meßelektrode verlötet wird, liegt das elektrodenseitige Ende des Innenleiters auf einer gewissen Länge frei.

Das Dokument DE-A-197 23 420 zeigt eine Schaitplatine mit einem Koaxialstecker, wobei ein hülsenförmiges Kontaktelement des Steckers auf einer Kontaktanschlussfläche (Masse) der Schaltungsplatine befestigt ist. Ein mittels eines Zentrierelements in dem hülsenförmigen Kontaktelement angeordneter Mittelleiter erstreckt sich durch eine Öffnung in der Schaltungsplatine hindurch und ist hier mittels eines elektrisch leitfähigen Kabels oder Drahtes mit einer Signalleitung verbunden.

Aufgabe der vorliegenden Erfindung ist es folglich, eine Anschlußvorrichtung für eine geschirmte Flächenelektrode vorzuschlagen, die die oben genannten Nachteile vermeidet.

Diese Aufgabe wird erfindungsgemäß gelöst durch eine Anschlußvorrichtung nach Anspruch 1. Die erfindungsgemäße Anschlußvorrichtung umfaßt ein hülsenförmiges Kontaktelement, das unmittelbar an der Abschirmelektrode derart montiert ist, daß es sich auf der der Meßelektrode abgewandten Seite der Abschirmelektrode im wesentlichen senkrecht von dieser erstreckt, wobei die Abschirmelektrode und die Abstandsschicht jeweils eine zu dem hülsenförmigen Kontaktelement koaxiale Öffnung aufweisen, ein stiftförmiges Kontaktelement, das unmittelbar an der Meßelektrode derart montiert ist, daß es sich auf der der Abschirmelektrode zugewandten Seite der Meßelektrode im wesentlichen senkrecht von dieser erstreckt, und ein hülsenförmiges Zentrierelement aus elektrisch isolierendem Material, dessen Länge kleiner als die Länge des hülsenförmigen Kontaktelements ist. Im zusammengebauten Zustand ist das hülsenförmige Zentrierelement elektrodenseitig in dem hülsenförmigen Kontaktelement angeordnet und das stiftförmige Kontaktelement erstreckt sich durch die Öffnungen in der Abstandsschicht und der Abschirmelektrode und durch das hülsenförmige Zentrierelement hindurch bis in das Innere des hülsenförmigen Kontaktelementes.

Auf diese Art wird eine vollkommen geschirmte Anschlußvorrichtung hergestellt, die sich durch den unmittelbaren Übergang der einzelnen Elektroden in das jeweilige Kontaktelement auszeichnet. Das stiftförmige Kontaktelement ist lediglich auf einer Distanz, die der Dicke der Abstandsschicht entspricht, nicht von dem hülsenförmigen Kontaktelement umgeben.

Die erfindungsgemäße Anschlußvorrichtung erlaubt darüber hinaus in einem hohen Maße den Einsatz von industriell vorgefertigter Teile, so daß sie bei dem Zusammenbau der Flächenelektrode leicht herstellbar ist, ohne daß mehrere weitere Arbeitsgänge notwendig werden. In der Tat können die verschiedenen Elektroden mit ihren jeweiligen Kontaktelementen vorgefertigt und die einzelnen Kontaktelemente und das Zentrierelement beim Zusammenbau der Flächenelektrode einfach zusammengesteckt und eventuell miteinander verklebt werden.

In einer bevorzugten Ausgestaltung der Erfindung weist das hülsenförmige Kontaktelement an seinem der Abschirmelektrode zugewandten Ende einen sich radial nach außen erstreckenden Montageflansch auf. Entsprechend weist das stiftförmige Kontaktelement vorzugsweise an seinem der Meßelektrode zugewandten Ende einen sich radial nach außen erstreckenden Montageflansch auf. Die Montage der einzelnen Kontaktelemente an ihren jeweiligen Elektroden kann daher flächig erfolgen, so daß eine höhere mechanische Belastbarkeit erreicht wird. Die Montage kann z.B. durch Punktschweißen der Montageflansche auf die jeweilige Elektrode erfolgen, wobei jeder Montageflansch mit mehreren verteilten Schweißpunkten fixiert wird.

Der äußere Durchmesser des stiftförmigen Kontaktelements und der innere Durchmesser des hülsenförmigen Zentrierelements bzw. der äußere Durchmesser des hülsenförmigen Zentrierelements und der innere Durchmesser des hülsenförmigen Kontaktelements sind vorteilhaft derart aufeinander abgestimmt, daß sich nach dem Zusammenbau zwischen den einzelnen Elementen eine reibschlüssige Verbindung ergibt.

In einer besonders bevorzugten Ausgestaltung, die sich insbesondere für den Einsatz an einer Flächenelektrode eignet, deren Abschirmelektrode und Meßelektrode jeweils ein Gestrick oder Gewirk aus elektrisch leitenden Fasern aufweisen, umfaßt einen Ring aus einem thermoplastischen, elektrisch isolierenden Material, der koaxial in der Öffnung der Abstandsschicht angebracht ist und durch den sich das stiftförmige Kontaktelement in zusammengebautem Zustand erstreckt, wobei der Ring aus thermoplastischen Material nach dem Zusammenbau der Kontaktelemente aufgeschmolzen wird. Beim Aufschmelzen des Rings, z.B. mittels Ultraschall, verläuft das flüssige Material in das Gestrick bzw. Gewirk der Abschirmelektrode und der Meßelektrode, so daß nach dem Erkalten des Rings ein fester Verbund der einzelnen Komponenten entsteht. Hierdurch werden zum einen die Schweißstellen der Kontaktelement geschützt, zum anderen erhält man eine besonders hohe mechanische Beanspruchbarkeit der Anschlußvorrichtung.

Die freien Enden des stiftförmigen und des hülsenförmigen Kontaktelements können derart ausgestaltet sein, daß in zusammengebautem Zustand ein geschirmtes Steckerelement, z.B. ein BNC-Stecker, ein SNB-Stecker, o.ä. ausgebildet wird. Alternativ sind die freien Enden des stiftförmigen und des hülsenförmigen Kontaktelements derart ausgestaltet sind, daß eine geschirmte Kontaktierung mittels Crimp-Verbindung ermöglicht wird.

Es ist anzumerken, daß die erfindungsgemäße Anschlußvorrichtung aufgrund ihrer besonderen Ausgestaltung senkrecht zu den jeweiligen Elektrodenflächen an einer Flächenelektrode vorteilhaft im Kreuzungspunkt der Diagonalen der Meßelektrode bzw. der Abschirmelektrode angeordnet werden kann. In der Tat erstrecken sich bei dieser Kontaktierung keine Kabel zwischen den beiden Elektroden, die den Sitzkomfort in einem Fahrzeugsitz erheblich beeinträchtigen können. Es wird hierdurch eine zentrale Kontaktierung der Meßelektrode und der Abschirmelektrode ermöglicht, was zu einer richtungsunabhängigen, niedrigen elektrischen Leitfähigkeit führt.

Im folgenden wird nun eine bevorzugte Ausgestaltung der Erfindung anhand der beiliegenden Figuren beschrieben. Es zeigen:
- Fig.1:: die verschiedenen Bestandteile einer geschirmten Flächenelektrode mit Anschlußvorrichtung für den Einsatz in einem Fahrzeugsitz
- Fig.2:: die Flächenelektrode aus Fig. 1 in zusammengebautem Zustand.

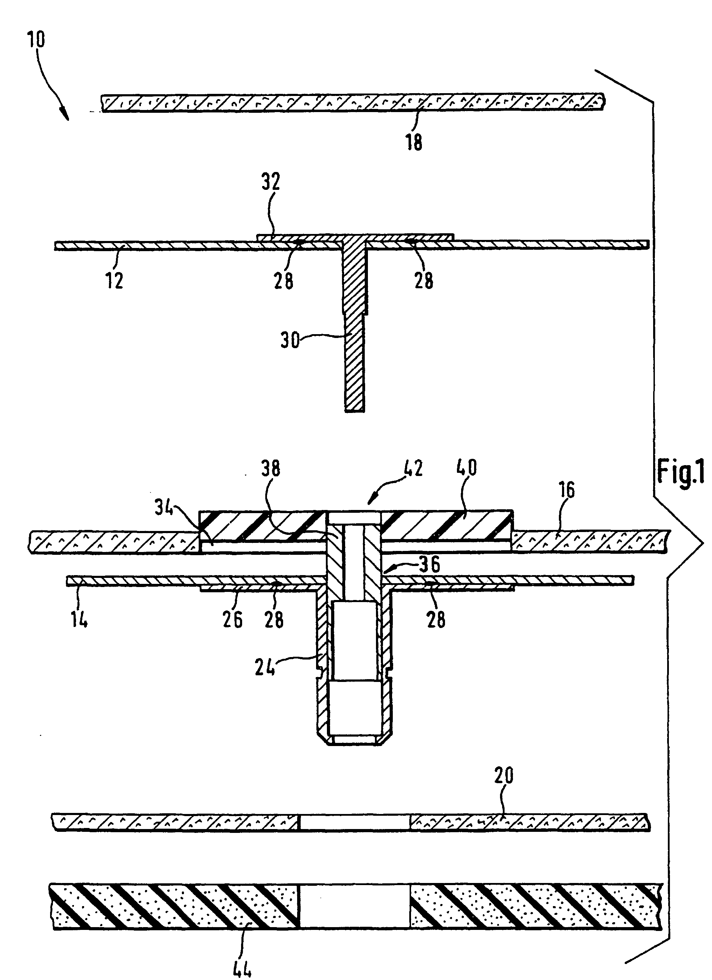

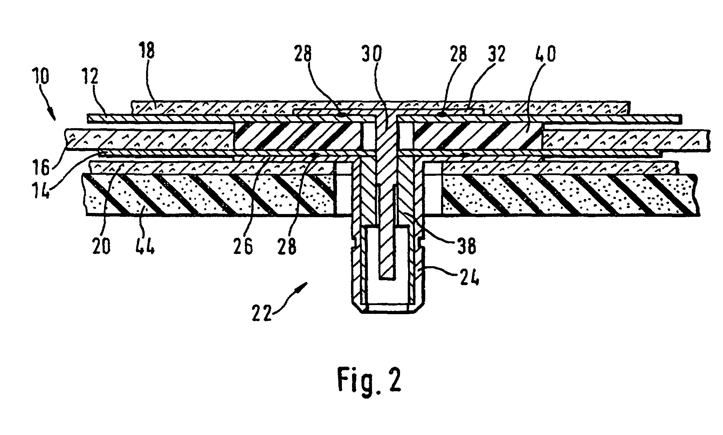

Fig.1 zeigt die verschiedenen Bauteile einer Flächenelektrode 10 für den Einsatz bei der kapazitiven Personendetektion in einem Fahrzeugsitz, während Fig.2 die zusammengebaute Elektrode zeigt.

Die Elektrode 10 umfaßt im wesentlichen eine flächige Meßelektrode 12 und eine flächige Abschirmelektrode 14 jeweils aus einem elektrisch leitenden Material sowie eine zwischen diesen beiden angeordnete Abstandsschicht 16 aus einem elektrisch isolierendem Material.

Die Meßelektrode 12 und die Abschirmelektrode 14 können beispielsweise aus einer Aluminiumfolie bestehen. In einer bevorzugten Ausgestaltung umfassen die beiden Elektroden 12, 14 jedoch ein Gestrick oder ein Gewirk aus elektrisch leitenden Fasern. Eine derartige gestrickte bzw. gewirkte Elektrode weist eine hohe Durchlässigkeit für Feuchtigkeit auf und kann somit allen Komfortanforderungen an einen Fahrzeugsitz genügen. Aus dem gleichen Grund umfaßt die Abstandsschicht 16 vorteilhaft eine Vliesschicht aus hydrophoben Material.

Um das aus Meßelektrode 12, Abstandsvlies 16 und Abschirmelektrode 14 gebildete Sandwich-Material besser handhabbar zu gestalten, wird vorteilhaft außen jeweils eine Vlieslage 18, 20 aufgelegt und mit dem Sandwich-Material verbunden. Auf diese Weise erhält man ein leicht handhabbares Material, daß sich beispielsweise sehr gut in einer gewünschten Form ausstanzen läßt.

Die Flächenelektrode 10 weist eine vorteilhafte Anschlußvorrichtung auf, die eine durchgehend geschirmte Kontaktierung erlauben.

Die Abschirmelektrode 14 ist hierzu mit einem hülsenförmigen Kontaktelement 24 versehen, das unmittelbar an dieser montiert ist und das sich auf der der Meßelektrode 12 abgewandten Seite im wesentlichen senkrecht von der Abschirmelektrode 14 erstreckt. Die Montage des hülsenförmigen Kontaktelements 24 erfolgt vorzugsweise mittels eines Monageflansches 26, der sich an dem elektrodenseitigen Ende des Kontaktelementes 24 radial von diesem erstreckt.

Die Meßelektrode 12 ist in ähnlicher Weise mit einem stiftförmigen Kontaktelement 30 versehen. Das stiftförmige Kontaktelement 30 ist unmittelbar an der Meßelektrode 12 montiert und erstreckt sich auf der der Abschirmelektrode 14 zugewandten Seite im wesentlichen senkrecht von der Meßelektrode 12. Die Montage des stiftförmigen Kontaktelements 30 erfolgt vorzugsweise ebenfalls mittels eines Monageflansches 32, der sich an dem elektrodenseitigen Ende des Kontaktelementes 30 radial von diesem erstreckt. Die Montageflansche 26, 32 ermöglichen eine flächige Verbindung der Kontaktelemente 24, 30 an der jeweiligen Elektrode 14, 12 und gewährleisten somit eine hohe mechanische Beanspruchbarkeit der Verbindung. Die Befestigung der Kontaktelementes 24, 30 kann beispielsweise durch Punktschweißen erfolgen, wobei mehrere Schweißpunkte 28 über die Fläche des jeweiligen Montageflansches verteilt sind.

In der dargestellten Ausführung der Flächenelektrode 10 ist das stiftförmige Kontaktelement 30 mit seinem Montageflansch an der Oberseite der Meßelektrode 12 montiert, wobei das stiftförmige Kontaktelement 30 durch eine Öffnung in der Meßelektrode 12 durchgeführt ist. In einer alternativen Ausgestaltung kann das stiftförmige Kontaktelement 30 auch an der Unterseite der Meßelektrode 12 befestigt sein, so daß sich ein Durchführen des Kontaktelements 30 durch die Elektrode erübrigt. Analog kann das hülsenförmige Kontaktelement 24 an der Oberseite der Abschirmelektrode 14 montiert sein und durch eine Öffnung in der Abschirmelektrode 14 durchgeführt werden.

Es ist weiterhin anzumerken, daß die Kontaktelemente 24 bzw. 30 mit ihren jeweiligen Montageflanschen 26 bzw. 30 einstückig ausgebildet oder aus verschiedenen Teilen zusammengesetzt sein können. Die Montageflansche können beispielsweise einfache Metallscheiben umfassen, die mit einer dem Durchmesser des jeweiligen Kontaktelementes entsprechenden Bohrung versehen sind, in die die Kontaktelemente eingeschweißt werden.

Das hülsenförmige Kontaktelement 24 und das stiftförmige Kontaktelement 30 sind derart an den jeweiligen Elektroden montiert, daß sie im wesentlichen koaxial zueinander angeordnet sind. Das stiftförmige Kontaktelement 30 kann dann beim Zusammenbau der Flächenelektrode 10 durch eine koaxiale Öffnung 34 in dem Abstandsvlies und eine koaxiale Öffnung 36 in der Abschirmelektrode 14 durchgeführt und in das Innere des hülsenförmigen Kontaktelements 24 eingeführt werden. Zur Zentrierung des stiftförmigen Kontaktelements 30 in dem hülsenförmigen Kontaktelement 24 ist ein hülsenförmiges Zentrierelement 38 vorgesehen, das elektrodenseitig in dem hülsenförmigen Kontaktelement 24 angeordnet ist. Die Länge des hülsenförmigen Zentrierelements 38 ist dabei derart gewählt, daß nach dem Zusammenbau der Anschlußvorrichtung, das freie Ende des stiftförmigen Kontaktelements 30 sich auf einer bestimmten Länge frei in dem hülsenförmigen Kontaktelement 24 erstreckt und so eine Kontaktierung ermöglicht wird. Der Innen- bzw. Außendurchmesser des hülsenförmigen Zentrierelements 38 ist an den Außendurchmesser des stiftförmigen Kontaktelements 30 bzw. den Innendurchmesser des hülsenförmigen Kontaktelements 24 derart angepaßt, daß sich nach dem Zusammenbau eine reibschlüssige Verbindung zwischen den einzelnen Bauteilen ergibt.

Um eine unlösbare Verbindung zwischen den einzelnen Steckerbauteilen zu erhalten, weist die Flächenelektrode 10 vorzugsweise einen Ring 40 aus einem thermoplastischen, elektrisch isolierenden Material auf, der koaxial in der Öffnung 34 der Abstandsschicht 16 angebracht ist. Der Ring weist ebenfalls eine koaxiale Öffnung 42 auf durch den sich das stiftförmige Kontaktelement 30 in zusammengebautem Zustand erstreckt. Nach dem Zusammenbau der Flächenelektrode, d.h. nach dem Zusammenstecken der einzelnen Anschlußelemente kann der Ring 40 z.B. mittels Ultraschall aufgeschmolzen werden, wobei das aufgeschmolzene Material in das Gestrick bzw. Gewirk der Abschirmelektrode 14 und der Meßelektrode 12 verläuft, so daß nach dem Erkalten des Rings 40 ein fester Verbund der einzelnen Komponenten entsteht. Hierdurch werden zum einen die Schweißstellen 28 der Kontaktelemente 24, 30 geschützt, zum anderen erhält man eine besonders hohe mechanische Beanspruchbarkeit der Anschlußvorrichtung.

Es bleibt anzumerken, daß die freien Enden des stiftförmigen Kontaktelements 30 und des hülsenförmigen Kontaktelements 24 derart ausgestaltet sein können, daß nach dem Zusammenbau der Anschlußvorrichtung ein geschirmtes Steckerelement, z.B. ein BNC-Stecker, ein SNB-Stecker, o.ä. ausgebildet wird. Alternativ können die Kontaktelemente für die Aufnahme einer Crimp-Verbindung optimiert sein.

Die derartig ausgestaltete Flächenelektrode zeichnet sich durch einen vollständig geschirmten Übergang zwischen den Elektroden und der Anschlußvorrichtung auf. Die Verbindung zwischen der Anschlußvorrichtung und der Flächenelektrode weist dabei eine sehr hohe mechanische Festigkeit auf, so daß eine besonders sichere Kontaktierung der Elektroden gewährleistet ist. Die Anschlußvorrichtung erstreckt sich im wesentlichen senkrecht nach unten, wobei sie in einfacher Weise durch Dürchführungsöffnungen in anderen Sitzkomponenten 44, wie z.B. eine Sitzbelegungserkennung oder eine Sitzheizung, isoliert durchgeführt wird. Durch eine geschickte Anordnung der Anschlußvorrichtung auf der Flächenelektrode kann die Durchführung an einer für die anderen Sitzkomponenten unkritischen Stelle erfolgen.

Ein weiterer Vorteil der beschriebenen Flächenelektrode ist die geringe Fühlbarkeit der Anschlußvorrichtung im Sitz, die den Ansprüchen an die Komforteigenschaften eines Sitzes vollkommen gerecht wird. In der Tat kann die Anschlußvorrichtung einen sehr geringen Durchmesser aufweisen, ohne daß hierunter die mechanische Festigkeit der Kontaktierung leidet.

## Patentansprüche

1. Geschirmte Flächenelektrode mit Anschlußvorrichtung, wobei die Flächenelektrode (10) eine flächige Meßelektrode (12) und eine in einem gewissen Abstand zu der Meßelektrode (12) angeordnete flächige Abschirmelektrode (14) umfaßt und wobei zwischen der Meßelektrode (12) und der Abschirmelektrode (14) eine Abstandsschicht (16) aus elektrisch isolierendem Material angeordnet ist, **gekennzeichnet durch**
ein hülsenförmiges Kontaktelement (24), das unmittelbar an der Abschirmelektrode (14) derart montiert ist, daß es sich auf der der Meßelektrode (12) abgewandten Seite der Abschirmelektrode (14) im wesentlichen senkrecht von dieser erstreckt, wobei die Abschirmelektrode (14) und die Abstandsschicht (16) jeweils eine zu dem hülsenförmigen Kontaktelement (24) koaxiale Öffnung (34, 36) aufweisen,
ein stiftförmiges Kontaktelement (30), das unmittelbar an der Meßelektrode (12) derart montiert ist, daß es sich auf der der Abschirmelektrode (14) zugewandten Seite der Meßelektrode (12) im wesentlichen senkrecht von dieser erstreckt, und
ein hülsenförmiges Zentrierelement (38) aus elektrisch isolierendem Material, dessen Länge kleiner als die Länge des hülsenförmigen Kontaktelements (24) ist,
wobei im zusammengebauten Zustand das hülsenförmige Zentrierelement (38) in dem hülsenförmigen Kontaktelement (24) angeordnet ist und sich das stiftförmige Kontaktelement (30) **durch** die Öffnungen in der Abstandsschicht (16) und der Abschirmelektrode (14) und **durch** das hülsenförmige Zentrierelement (38) hindurch bis in das Innere des hülsenförmigen Kontaktelementes (24) erstreckt.

2. Flächenelektrode nach Anspruch 1, **dadurch gekennzeichnet, daß** das hülsenförmige Kontaktelement (24) an seinem der Abschirmelektrode (14) zugewandten Ende einen sich radial nach außen erstreckenden Montageflansch (26) aufweist.

3. Flächenelektrode nach einem der Ansprüche 1 oder 2, **dadurch gekennzeichnet, daß** das stiftförmige Kontaktelement (30) an seinem der Meßelektrode (12) zugewandten Ende einen sich radial nach außen erstreckenden Montageflansch (32) aufweist.

4. Flächenelektrode nach einem der Ansprüche 1 bis 3, **dadurch gekennzeichnet, daß** der äußere Durchmesser des stiftförmigen Kontaktelements (30) und der innere Durchmesser des hülsenförmigen Zentrierelements (38) bzw. der äußere Durchmesser des hülsenförmigen Zentrierelements (38) und der innere Durchmesser des hülsenförmigen Kontaktelements (24) derart aufeinander abgestimmt sind, daß sich nach dem Zusammenbau zwischen den einzelnen Elementen eine reibschlüssige Verbindung ergibt.

5. Flächenelektrode nach einem der Ansprüche 1 bis 4, wobei die Abschirmelektrode (14) und die Meßelektrode (12) jeweils ein Gestrick oder Gewirk aus elektrisch leitenden Fasern aufweisen, **gekennzeichnet durch** einen Ring (40) aus einem thermoplastischen, elektrisch isolierenden Material, der koaxial in der Öffnung (34) der Abstandsschicht (16) angebracht ist und **durch** den sich das stiftförmige Kontaktelement (30) in zusammengebautem Zustand erstreckt, wobei der Ring (40) aus thermoplastischen Material nach dem Zusammenbau der Kontaktelemente aufgeschmolzen wird.

6. Flächenelektrode nach einem der Ansprüche 1 bis 5, **dadurch gekennzeichnet, daß** die freien Enden des stiftförmigen und des hülsenförmigen Kontaktelements derart ausgestaltet sind, daß in zusammengebautem Zustand ein geschirmtes Steckerelement ausgebildet wird.

7. Flächenelektrode nach einem der Ansprüche 1 bis 5, **dadurch gekennzeichnet, daß** die freien Enden des stiftförmigen und des hülsenförmigen Kontaktelements derart ausgestaltet sind, daß eine Kontaktierung mittels Crimp-Verbindung ermöglicht wird.

8. Flächenelektrode nach einem der vorhergehenden Ansprüche, **dadurch gekennzeichnet, daß** das hülsenförmige Kontaktelement (24) und das stiftförmige Kontaktelement (30) mit der jeweiligen Elektrode verschweißt werden.

9. Flächenelektrode nach einem der Ansprüche 1 bis 8, **dadurch gekennzeichnet, daß** die Anschlußvorrichtung im wesentlichen im Kreuzungspunkt der Diagonalen der Meßelektrode bzw. der Abschirmelektrode angeordnet ist.

## Claims

1. Screened surface electrode having a connection device, the surface electrode (10) comprising a flat measuring electrode (12) and a flat screening electrode (14), arranged at a certain distance from the measuring electrode (12), and a spacer layer (16) made of electrically insulating material being arranged between the measuring electrode (12) and the screening electrode (14), **characterized by**
a sleeve-like contact element (24), which is mounted directly on the screening electrode (14) such that it extends essentially perpendicularly from the screening electrode (14) on the side of said screening electrode (14) which is remote from the measuring electrode (12), the screening electrode (14) and the spacer layer (16) each having an opening (34, 36) which is coaxial to the sleeve-like contact element (24),
a pin-like contact element (30), which is mounted directly on the measuring electrode (12) such that it extends essentially perpendicularly from the measuring electrode (12) on the side of said measuring electrode (12) which faces the screening electrode (14), and
a sleeve-like centring element (38) made of electrically insulating material, which is smaller in length than the sleeve-like contact element (24),
when assembled, the sleeve-like centring element (38) being arranged in the sleeve-like contact element (24), and the pin-like contact element (30) extending through the openings in the spacer layer (16) and the screening electrode (14) and through the sleeve-like centring element (38) into the interior of the sleeve-like contact element (24).

2. Surface electrode according to Claim 1, **characterized in that** the sleeve-like contact element (24) has a radially outwardly extending mounting flange (26) on its end facing the screening electrode (14).

3. Surface electrode according to either Claim 1 or 2, **characterized in that** the pin-like contact element (30) has a radially outwardly extending mounting flange (32) on its end facing the measuring electrode (12).

4. Surface electrode according to one of Claims 1 to 3, **characterized in that** the outer diameter of the pin-like contact element (30) and the inner diameter of the sleeve-like centring element (38) resp. the outer diameter of the sleeve-like centring element (38) and the inner diameter of the sleeve-like contact element (24) are matched to one another such that, after assembly, a friction-locking connection results between the individual elements.

5. Surface electrode according to one of Claims 1 to 4, the screening electrode (14) and the measuring electrode (12) each having a mesh or weave of electrically conductive fibres, **characterized by** a ring (40) made of a thermoplastic, electrically insulating material, which is applied coaxially in the opening (34) in the spacer layer (16) and through which, when assembled, the pin-like contact element (30) extends, the ring (40) made of a thermoplastic material being fused after assembly of the contact elements.

6. Surface electrode according to one of Claims 1 to 5, **characterized in that** the free ends of the pin-like contact element and the sleeve-like contact element are designed such that, when assembled, a screened connector element is formed.

7. Surface electrode according to one of Claims 1 to 5, **characterized in that** the free ends of the pin-like contact element and the sleeve-like contact element are designed such that it is possible for contact to be made by means of a crimp connection.

8. Surface electrode according to one of the preceding claims, **characterized in that** the sleeve-like contact element (24) and the pin-like contact element (30) are welded to the respective electrode.

9. Surface electrode according to one of Claims 1 to 8, **characterized in that** the connection device is arranged essentially at the point at which the diagonals of the measuring electrode resp. the screening electrode cross.

## Revendications

1. Électrode de surface blindée avec un dispositif de connexion, l'électrode de surface (10) comprenant une électrode de mesure plane (12) et une électrode de blindage plane (14), disposée à une certaine distance de l'électrode de mesure (12) et une couche d'écartement (16) en matière assurant une isolation électrique étant disposée entre l'électrode de mesure (12) et l'électrode de blindage (14), **caractérisée par** un élément de contact en forme de douille (24), qui est monté directement sur l'électrode de blindage (14) de façon à ce que sur la face opposée à l'électrode de mesure (12), de l'électrode de blindage (14), il s'étende sensiblement perpendiculaire à partir de cette dernière, l'électrode de blindage (14) et la couche d'écartement (16) étant munies respectivement d'un orifice coaxial (34, 36) donnant sur l'élément de contact en forme de douille (24),
un élément de contact en forme de tige (30) étant directement monté sur l'électrode de mesure (12), de façon à ce que sur la face dirigée vers l'électrode de blindage (14) de l'électrode de mesure (12) il s'étende sensiblement perpendiculaire à partir de cette dernière, et
un élément de centrage en forme de douille (38) en matière assurant une isolation électrique, dont la longueur est inférieure à la longueur de l'élément de contact en forme de douille (24),
à l'état assemblé, l'élément de centrage en forme de douille (38) étant disposé dans l'élément de contact en forme de douille (24) et l'élément de contact en forme de tige (30) s'étendant à travers les orifices dans la couche d'écartement (16) et dans l'électrode de blindage (14) et à travers l'élément de centrage en forme de douille (38) jusqu'à l'intérieur de l'élément de contact en forme de douille (24).

2. Électrode de surface selon la revendication 1, **caractérisée en ce que** l'élément de contact en forme de douille (24) est muni sur son extrémité dirigée vers l'électrode de blindage (14) d'une bride de montage (26) qui s'étend de façon radiale vers l'extérieur.

3. Électrode de surface selon l'une quelconque des revendications 1 ou 2, **caractérisée en ce que** l'élément de contact en forme de tige (30) est muni sur sont extrémité dirigée vers l'électrode de mesure (12) d'une bride de montage (32) s'étendant de façon radiale vers l'extérieur.

4. Électrode de surface selon l'une quelconque des revendications 1 à 3, **caractérisée en ce que** le diamètre extérieur de l'élément de contact en forme de tige (30) et le diamètre intérieur de l'élément de centrage en forme de douille (38) resp.le diamètre extérieur de l'élément de centrage en forme de douille (38) et le diamètre intérieur de l'élément de contact en forme de douille (34) sont adaptés entre eux de façon telle qu'à l'issue de l'assemblage, on obtienne une liaison par complémentarité de frottement entre les éléments individuels.

5. Électrode de surface selon l'une quelconque des revendications 1 à 4, l'électrode de blindage (14) et l'électrode de mesure (12) étant respectivement munies d'un maillage ou d'un tissage en fibres conductrices d'électricité, **caractérisée par** une bague (40) en matière thermoplastique assurant l'isolation électrique, qui est montée de façon coaxiale dans l'orifice (34) de la couche d'écartement (16) et à travers laquelle l'élément de contact en forme de tige (30) s'étend à l'état monté, la bague (40) en matière thermoplastique étant soumise à une fusion après l'assemblage des éléments de contact.

6. Électrode de surface selon l'une quelconque des revendications 1 à 5, **caractérisée en ce que** les extrémités libres de l'élément de contact en forme de tige et de l'élément de contact en forme de douille sont conçues de façon à ce qu'à l'état monté, on obtienne un élément connecteur blindé.

7. Électrode de surface selon l'une quelconque des revendications 1 à 5, **caractérisée en ce que** les extrémités libres de l'élément de contact en forme de tige et de l'élément de contact en forme de douille sont conçues de façon à permettre une connexion à l'aide d'une liaison par crampon.

8. Électrode de surface selon l'une quelconque des revendications précédentes, **caractérisée en ce que** l'élément de contact en forme de douille (24) et l'élément de contact en forme de tige (30) sont soudés avec l'électrode respective.

9. Électrode de surface selon l'une quelconque des revendications 1 à 8, **caractérisée en ce que** le dispositif de connexion est sensiblement disposé à l'intersection des diagonales de l'électrode de mesure resp. de l'électrode de blindage.
